# EUROPEAN PATENT APPLICATION

(11) **EP 2 427 039 A1**
(43) Date of publication of application: **07.03.2012**
(21) Application number: 10175224.4
(22) Date of filing: 03.09.2010
(51) Int. Cl.: H05K 9/00, H01B 1/24

(54) **Process for preparing electromagnetic interference shielding materials.**

(71) Applicant: Université Catholique de Louvain, 1348 Louvain-La-Neuve (BE); Université de Liège, 4031 Angleur (BE)
(72) Inventor: Thomassin, Jean-Michel, 4670, BLEGNY (BE); Jerome, Christine, 4102, OUGREE (BE); Detrembleur, Christophe, 4130, ESNEUX (BE); Alexandre, Michaël, 4102, OUGREE (BE); Huynen, Isabelle, 1348, LOUVAIN-LA-NEUVE (BE)
(74) Representative: Pecher, Nicolas

(57) **Abstract**

The present invention relates to a process for preparing an electromagnetic interference shielding material, or a precursor thereof, comprising a first polymer matrix and carbon conductive loads, said process comprises the steps of:
(a) Forming a reaction mixture comprising carbon conductive loads and a polymerizable medium said polymerizable medium comprising one or more monomers dissolved in a solvent,
(b) Exposing the reaction mixture to polymerization conditions to polymerize said polymerizable medium and thus form a polymer, and
(c) Forming a precipitate or an agglomerate of an electromagnetic interference shielding material made of less than 50 wt.% carbon conductive loads dispersed in the first polymer matrix formed in step (b),

characterized in that, said polymer is insoluble in said solvent and in that a fraction of the polymer chains thus formed are grafted on part of the surface of the carbon conductive loads.

## Description

### TECHNICAL FIELD

The present invention relates generally to the field of electromagnetic interference shielding materials. In particular, the present invention relates to a process for preparing electromagnetic interference shielding materials comprising carbon conductive loads, such as nanotubes or carbon black.

### DESCRIPTION OF RELATED ART

Nanocomposites filled with carbon nanofillers have received steadily increased attention during the last few years due to their potential application in biomedical applications (Verdejo et al. J. Biomed. Mater. Res. Part A, 2008, 88A, 65-73), acoustic absorption (Verdejo et al. Eur. Polym. J., 2008, 44, 2790-2797; Verdejo et al. Compos. Sci. Technol., 2009, 69, 1564-1569), electromagnetic interferences shielding (Thomassin et al. J. Mater. Chem. 2008, 18, 792-796; Yang et al. Nano Lett., 2005, 5, 2131-2134; WO2008068042) and electrostatic discharge (ESD) applications (Park et al., J. Applied. Polym. Sci., 2009, 112, 1845-1849; KR2006009721). Indeed, they benefit from the low weight, low thermal conductivity, low dielectric constant and good sound isolation inherent to the polymeric matrix, in particular when foams are used, together with the electrical conductivity and mechanical reinforcement properties of the carbon nanofillers. This combination of properties is particularly interesting for the preparation of materials able to absorb incident electromagnetic radiations in a broad frequency range without reflecting them. These materials must indeed exhibit both a high electrical conductivity to absorb the electromagnetic radiation by conductive dissipation with a low dielectric constant to keep the reflectivity low. It is noted that clusters or aggregates of carbon conductive loads optionally grafted or adsorbed with polymer chains (e.g. Guo et al. Macromolecules 2006, 39, 9035-9040) are not nanocomposites as such due to their low amount of polymer with respect to the carbon conductive loads which makes their shaping impossible. At best they can serve as precursors for preparing an electromagnetic shielding material by mixing them with a polymeric matrix. Handling of such carbon loads grafted with polymer chains, however, is difficult as these particulate materials are toxic to inhale. For these reasons, many manufacturers are reluctant to use such material precursors, which require special security working conditions.

Electromagnetic interference shielding materials comprise a polymer matrix and carbon conductive loads dispersed therein, generally in the range of 0.5 to 5.0 wt.% carbon conductive loads. The first step in the preparation of electromagnetic interference shielding materials is the dispersion of carbon conductive loads within the polymer matrix which is a fundamental step since the conductivity of the resulting materials will directly depend on the level of homogeneity of the dispersion. The quality of dispersion must therefore be optimized. It must be high enough for the establishment of a conductive network all along the material. However, attention must be paid to not completely isolate the carbon conductive loads, which would cut any contact between them at reasonable loadings (few wt%). Moreover, the dispersion method must be sufficiently gentle to avoid extensive breaking of the carbon conductive loads that would be detrimental to the electrical conductivity.

Melt-mixing methods have been among the most studied dispersion techniques due to their easy up scaling to industrial levels of production. The melt-mixing method consists of mixing carbon conductive loads and a polymer melt at high temperature and shear by extrusion. While the dispersion of carbon conductive loads thus obtained can be good, the resulting conductivity is generally hindered as a result of the short length of the cut carbon conductive loads exposed to severe shear conditions and the low extent of contacts between too perfectly dispersed carbon conductive loads.

Other dispersion methods have been implemented such as co-precipitation, bulk polymerization or suspension polymerization. Co-precipitation consists of solubilizing the polymer in a solvent, dispersing carbon conductive loads therein and precipitating the polymer composite with a non-solvent of the polymer. Although this technique has demonstrated very high efficiency due to the preservation of the carbon conductive loads structure (less aggressive dispersion methods) and contacts between them, it consumes unacceptably large amounts of solvent and non-solvent. It follows that this technique is hardly transferable to an industrial scale due to the large amounts of solvent used: polymerization or dispersion in a given volume, V of a good solvent of the polymer and precipitation in at least 10 times the volume, V, (= 10 V) of a non solvent. For example, JP59217715 discloses such co-precipitation process for preparing carbon black-containing polystyrene resin.

JP3215502 discloses a method for suspension polymerization. The monomer is dispersed in aqueous medium such as water to form droplets thereof. Hence, the monomer is not soluble in the aqueous medium. Droplets are polymerized in a second step optionally in presence of surfactants or emulsifying agent. However, it is difficult to remove undesired components such as emulsifying agents and the like. The suspension polymerization method has disadvantages that it is expensive and quite complex and is thus ill fitted to up scaling to industrial levels of production.

Therefore, there is a need for a process for preparing electromagnetic interference shielding materials comprising carbon conductive loads that overcomes the above-discussed drawbacks of the prior art. There is also a need for precursors of electromagnetic shielding materials which can be handled simply and without risk for the health.

### SUMMARY OF THE INVENTION

It is an object of the present invention to provide a process for preparing an electromagnetic interference shielding material or a precursor thereof, which requires low to moderate amounts of solvents. It is another object to provide a process whereby an electromagnetic interference shielding material having excellent shielding effectiveness properties is obtained. It is another object to provide a process whereby an electromagnetic interference shielding material having low reflectivity is obtained. It is yet another object of the invention to provide a process whereby an electromagnetic interference shielding material having excellent electrical conductivity is obtained. It is another object of the invention to provide an electromagnetic interference shielding material having the above-mentioned properties with low loading of carbon conductive loads.

In a first aspect, a process for preparing an electromagnetic interference shielding material, or a precursor thereof, comprising a first polymer matrix and carbon conductive loads is provided. In particular, the process comprises the steps of:
(a) Forming a reaction mixture comprising carbon conductive loads and a polymerizable medium said polymerizable medium comprising one or more monomers dissolved in a solvent,
(b) Exposing the reaction mixture to polymerization conditions to polymerize said polymerizable medium and thus form a polymer, and
(c) Forming a precipitate or an agglomerate of an electromagnetic interference shielding material made of less than 50 wt.% carbon conductive loads dispersed in the first polymer matrix formed in step (b),
characterized in that said polymer is insoluble in said solvent and in that a fraction of the polymer chains thus formed are grafted on part of the surface of the carbon conductive loads.

The process of the present invention combines the advantages of the melt-mixing (industrial applicability) and co-precipitation techniques (preservation of carbon conductive loads structure) while scaling-up is not a problem. As it is being polymerized, the polymer matrix precipitates and entraps all the carbon conductive loads. The amount of solvent to be used is strongly decreased compared with the co-precipitation technique that needs to first dissolve the polymer in the presence of carbon conductive loads in a good solvent before precipitation in a huge amount of poor solvent of the polymer. The electromagnetic interference shielding materials which are obtained by the present process exhibit excellent shielding effectiveness, electrical conductivity and/or low reflectivity.

In a second aspect, the invention provides an electromagnetic interference shielding material or a precursor thereof formed by the process according to the present invention.

In a third aspect, the invention provides a method for shielding a surface or a volume from a source of electromagnetic radiations comprising the steps of:
- Preparing an electromagnetic interference shielding material by the process according to the present invention,
- Shaping said electromagnetic interference shielding material to form an electromagnetic interference shield, and
- Interposing said electromagnetic interference shield between said surface or volume and said source of electromagnetic radiation.

### BRIEF DESCRIPTION OF THE DRAWING

Fig.1 represents the electrical conductivity as a function of frequency of an electromagnetic interference shielding material made of poly(methyl methacrylate) and carbon nanotubes prepared by various methods.

Fig. 2a and 2b represent the shielding effectiveness and the reflectivity respectively as a function of frequency of two electromagnetic interference shielding materials according to the present invention comprising poly(methyl methacrylate) and carbon nanotubes, one being foamed.

Fig. 3a and 3b represent the electrical conductivity as a function of frequency of materials made of poly(methyl methacrylate) and carbon nanotubes, in poly(styrene-co-acrylonitrile) prepared by various methods.

### DETAILED DESCRIPTION OF THE INVENTION

The present invention is defined in the appended independent claims. Preferred embodiments are defined in the dependent claims. In particular, the present invention provides a process for preparing an electromagnetic interference shielding material, or a precursor thereof, comprising a first polymer matrix and carbon conductive loads, said process comprises the steps of:
(a) Forming a reaction mixture comprising carbon conductive loads and a polymerizable medium said polymerizable medium comprising one or more monomers dissolved in a solvent,
(b) Exposing the reaction mixture to polymerization conditions to polymerize said polymerizable medium and thus form a polymer, and
(c) Forming a precipitate or an agglomerate of an electromagnetic interference shielding material made of less than 50 wt.% carbon conductive loads dispersed in the first polymer matrix formed in step (b),
characterized in that, said polymer is insoluble in said solvent and in that a fraction of the polymer chains thus formed are grafted on part of the surface of the carbon conductive loads.

The term "electromagnetic interference shielding material" (EMI shielding material) or simply "electromagnetic shielding material", refer to a material having a polymer matrix loaded with less than 5.0 wt.% of carbon conductive loads dispersed therein, preferably between 0.5 and 4.0 wt.%, more preferably between 0.5 and 2.0 wt.%. An "electromagnetic interference shielding material precursor" or simply "electromagnetic shielding material precursor", refers to a material having a polymer matrix loaded with more than 0.5 wt.% and less than 50 wt% of carbon conductive loads dispersed therein, preferably between 3.0 and 40wt%, more preferably between 4.0 and 20wt%, most preferably between 5.0 and 10 wt.%. An electromagnetic shielding material precursor can be used to taylor the content in carbon conductive loads by simply mixing it with a pure polymer, or a nanocomposite comprising a lower content in carbon conductive loads, to form an EMI shielding material with a desired carbon content between 0.5 and 5.0 wt.%.

The term "one or more monomers" refers to 1 to 10, preferably 1 to 5, more preferably 1 or 2 monomers. The term "carbon conductive loads" as used herein refers to carbon based conductive materials, especially nanoscopic carbon based charges that can be incorporated in a polymer matrix, such as e.g. carbon nanotubes (CNT), carbon black (CB) particles, carbon nanofibers (CNF), graphene or any combination thereof. The CNTs may have a high length to diameter aspect ratio, L/D, of at least 10, preferably at least 100, more preferably at least 500, most preferably at least 1000. The CNTs may have a length of between 100 nm and 500 µm, for example between 100 nm and 100 µm or between 100 nm and 250 µm. The carbon black particles may have a diameter of between 100 nm and 500 µm, for example between 100 nm and 250 µm. The CNFs may have a length of between 100 nm and 500 µm, for example between 100 nm and 100 µm or between 100 nm and 250 µm. Carbon nanotubes (CNTs) may offer substantial advantages over conventional carbon fillers because they can simultaneously enhance the electrical conductivity and reinforce the mechanical performances of the filled polymers at very low contents (<5 wt %) as result of their high aspect ratio (> 1000) and their nanoscopic dimension.

Whenever the term "substituted" is used in the present invention, it is meant to indicate that one or more hydrogen on the atom indicated in the expression using "substituted" is independently replaced with a selection from the indicated group of substituents, provided that the indicated atom's normal valence is not exceeded, and that the substitution results in a chemically stable compound, i.e. a compound that is sufficiently robust to survive isolation to a useful degree of purity from a reaction mixture. Unless specific mention, in the present invention the substituents may be independently selected from the group consisting of C₁₋₁₀ alkyl, C₆₋₁₀ aryl, C₃₋₁₀ cycloalkylene, C₃₋₁₀ cycloalkyl, F, Br, Cl, I, OR, COOR, NR₂, SO₃R, and -P(O)(OR)₂, wherein R is selected from the group consisting of hydrogen, C₁₋₁₀ alkyl, C₃₋₁₀ cycloalkylene, C₃₋₁₀ cycloalkyl and C₆₋₁₀ aryl.

The term "alkyl" by itself or as part of another substituent refers to a linear or branched hydrocarbyl radical of formula CₘH₂ₘ₊₁ wherein m is a integer greater than or equal to 1. Generally, alkyl groups of the present invention comprise from 1 to 10 carbon atoms. For example, the "C₁-C₁₀ alkyl" refers but is not limited to methyl, ethyl, n-propyl, i-propyl, n-butyl, i-butyl, s-butyl, t-butyl, 1-pentyl, 2-pentyl, 3-pentyl, i-pentyl, neo-pentyl, t-pentyl, 1-hexyl, 2-hexyl, 3-hexyl, 1-methyl-1-ethyl-n-pentyl, 1,1,2-tri-methyl-n-propyl, 1,2,2-trimethyl-n-propyl, 3,3-dimethyl-n-butyl, 1-heptyl, 2-heptyl, 1-ethyl-1,2-dimethyl-n-propyl, 1-ethyl-2,2-dimethyl-n-propyl, 1-octyl, 3-octyl, 4-methyl-3-n-heptyl, 6-methyl-2-n-heptyl, 2-propyl-1-n-heptyl, 2,4,4-trimethyl-1-n-pentyl, 1-nonyl, 2-nonyl, 2,6-dimethyl-4-n-heptyl, 3-ethyl-2,2-dimethyl-3-n-pentyl, 3,5,5-trimethyl-1-n-hexyl, 1-decyl, 2-decyl, 4-decyl, 3,7-dimethyl-1-n-octyl, 3,7-dimethyl-3-n-octyl.

The term "cycloalkyl" by itself or as part of another substituent refers to a cyclic hydrocarbyl radical of formula CₚH₂p₋₁ wherein p is an integer greater than or equal to 3, preferably p is between 3 and 10. For example, "C₃-C₁₀ cycloalkyl" refers but is not limited to cyclopropane, cyclobutane, cyclopentane, cyclohexane, cycloheptane, cyclooctane, cyclononane, cyclodecane. Cycloalkyl groups may be substituted by one or more of substituents as defined above.

The term "cycloalkene" by itself or as part of another substituent refers to a non aromatic cyclic hydrocarbon comprising more than 3 carbon atoms, preferably from 3 to 10 carbon atoms, and having one or more double or triple carbon-carbon bond(s). Non limitative examples are cyclopropene, cyclobutene, cyclopentene, cyclohexene, cycloheptene, cyclooctene, cyclobutadiene, cyclopentadiene, cyclohexadiene, cycloheptadiene, cyclooctadiene. The term "cycloalkylene" refers to cycloalkene hydrocarbon radical. Cycloalkylene and cycloalkene may be substituted by one or more of substituents as defined above.

The term "aryl" by itself or as part of another substituent refers to a polyunsaturated, aromatic hydrocarbyl group having a single ring (i.e. phenyl) or multiple aromatic rings fused together (e.g. naphtyl) or linked covalently, typically containing 6 to 10 carbon atoms, wherein at least one ring is aromatic. Non-limiting examples of aryl comprise phenyl, biphenylyl, biphenylenyl, tetralinyl, azulenyl, naphthalenyl, indenyl, acenaphtenyl, phenanthryl, indanyl, pyrenyl. Aryl groups may be substituted by one or more of substituents as defined above.

According to the present invention, said one or more monomers used are soluble in said solvent while the corresponding first polymer matrix formed during the process precipitates or agglomerates in said solvent and is therefore insoluble therein.

Said one or more monomers may be independently selected from the group consisting of:
- C₃₋₁₀ cycloalkene or an alkene of general formula R¹R²C=CR³R⁴ wherein R¹, R², R³, R⁴ are substituent independently selected from the group consisting of hydrogen, -OR, -CN, -COOR, -NR₂, -SO₃R, -P(O)(OR)₂, and unsubstituted or substituted C₁₋₁₀ alkyl, C₃₋₁₀ cycloalkylene, C₃₋₁₀ cycloalkyl or C₆₋₁₀ aryl groups;
- hydroxyalkanoate of general formula HO-(CR⁵R⁶)ₙ-CO₂H wherein n is an integer from 1 to 10, R⁵ and R⁶ are independently selected in each n units from the group consisting of hydrogen, and unsubstituted or substituted C₁₋₁₀ alkyl, C₃₋₁₀ cycloalkylene, C₃₋₁₀ cycloalkyl or C₆₋₁₀ aryl groups,
- a mixture of diol or polyols and diisocyanates or polyisocyanates having from 2 to 20 aliphatics, araliphatics or cycloaliphatics carbons, the prefix "poly" as used herein refers to compounds bearing more than two hydroxyl or isocyanate functional groups,
- compound of general formula X¹-R⁶-X² wherein X¹ and X² are functional groups selected from the group consisting of CO₂H, NH₂, OH, halogen, -S(O)₂-R⁷ and salts thereof; R⁶ and R⁷ are independently selected from the group consisting of unsubstituted or substituted C₁₋₁₀ alkyl, C₃₋₁₀ cycloalkylene, C₃₋₁₀ cycloalkyl or C₆₋₁₀ aryl groups,
- a mixture comprising a ketone of general formula X³-R^{$}-CO-R⁹-X⁴ and an dialkoxide HO-R¹⁰-OH or salts thereof, wherein R⁸, R⁹, R¹⁰ are independently selected from the group consisting of and unsubstituted or substituted C₁₋₁₀ alkyl, C₃₋₁₀ cycloalkylene, C₃₋₁₀ cycloalkyl or C₆₋₁₀ aryl groups; X³ and X⁴ are independently selected from the group consisting of F, Br, Cl and I, and
- a mixture comprising a dianhydride and a compound of general formula X⁵-R¹¹-X⁶ and wherein X⁵ and X⁶ are functional groups selected from the group consisting of NH₂ and N=C=O, and R¹¹ is unsubstituted or substituted C₁₋₁₀ alkyl, C₃₋₁₀ cycloalkylene, C₃₋₁₀ cycloalkyl or C₆₋₁₀ aryl groups; or ether of general formula R¹²-O-R¹³ wherein R¹² and R¹³ are independently selected from the group consisting of unsubstituted or substituted C₁₋₁₀ alkyl, C₃₋₁₀ cycloalkylene, C₃₋₁₀ cycloalkyl and C₆₋₁₀ aryl groups.

Preferably, said one or more monomers may be independently selected from the group consisting of C₃₋₁₀ cycloalkene or an alkene of general formula R¹R²C=CR³R⁴ wherein R¹, R², R³, R⁴ are substituent independently selected from the group consisting of hydrogen, -OR, -CN, -COOR, -NR₂, - SO₃R, -P(O)(OR)₂, and unsubstituted or substituted C₁₋₁₀ alkyl, C₃₋₁₀ cycloalkylene, C₃₋₁₀ cycloalkyl or C₆₋₁₀ aryl groups.

Examples of diols are ethylene glycol, diethylene glycol, triethylene glycol, tetraethylene glycol, dipropylene glycol, tripropylene glycol, 1,2-propanediol, 1,3-propanediol, 1,4-butanediol, 1,4-butanediol, neopentyl glycol, 2-ethyl-2-butylpropanediol, trimethylpentanediol, the isomers of diethyloctanediol, 1,3-butylene glycol, cyclohexanediol, 1,4-cyclohexanedimethanol, 1,6-hexanediol, 1,2- and 1,4-cyclohexanediol, hydrogenated bisphenol A (2,2-bis(4-hydroxycyclohexy- I)propane), 2,2-dimethyl-3-hydroxypropyl, 2,2-dimethyl-3-hydroxypropionate. Examples of triols are trimethylolethane, trimethylolpropane or glycerol. Examples of polyols are ditrimethylolpropane, pentaerythritol, dipentaerythritol and sorbitol. Particular diols or polyols which may be used are 1,4-butanediol, 1,4-cyclohexanedimethanol, 1,6-hexanediol and trimethylol propane. Said diisocyanates or polyisocyanates may be e aromatic, araliphatic, aliphatic or cycloaliphatic di- or polyisocyanates. Examples of suitable diisocyanates or polyisocyanates which may be used with the method according to embodiments of the invention may be butylene diisocyanate, hexamethylene diisocyanate (HDI), isophorone diisocyanate (IPDI), 2,2,4- and/or 2,4,4-thmethylhexamethylene diisocyanate, the isomeric bis (4,4'-isocyanatocyclohexyl)methanes or mixtures thereof of any desired isomer content, isocyanatomethyl-1,8-octane diisocyanate, 1,4-cyclohexylene diisocyanate, the isomeric cyclohexanedimethylene diisocyanates, 1,4-phenylene diisocyanate, 2,4- and/or 2,6-tolylene diisocyanate, 1,5-naphthylene diisocyanate, 2,4'- or 4,4'-diphenylmethane diisocyanate, triphenylmethane- 4,4',4"-triisocyanate or derivatives thereof with a urethane, urea, carbodiimide, acylurea, isocyanurate, allophanate, biuret, oxadiazinetrione, uretdione, iminooxadiazinedione structure and mixtures thereof.

The solvent used in the process of the present invention may be a polar or an apolar solvent. The solvent used to prepare said electromagnetic interference shielding material or a precursor thereof is selected to dissolve said one or more monomer(s) but not the first polymer matrix formed after exposing to polymerization conditions. Said solvent may be selected from the group consisting of supercritical carbon dioxide, C₅₋₁₅ alkane, C₁₋₁₀ alcohol, hydrocarbon bearing a functional group selected from the group consisting of ether, ester, ketone, aldehyde, sulfoxide, nitrile, and amide; water and unsubstituted or substituted C₆₋₁₀ aryl groups. Preferably, said solvent may be C₁₋₁₀ alcohol and supercritical carbon dioxide.

The polymerization medium may further comprise a polymerization catalyst and/or initiator. A man skilled in the art will know if such catalyst is necessary or not depending on the monomer(s) selected. The polymerization catalyst may be homogeneous or heterogeneous catalyst. Additional components may be added to the reaction mixture to obtain the desired electromagnetic interference shielding material. For example, when the first polymer matrix to be formed is polycarbonate, phosgene and carbonate can be added to the reaction mixture.

According to the invention, the reaction mixture is exposed to polymerization conditions to form a solvent-insoluble electromagnetic interference shielding material, or a precursor thereof, having carbon conductive loads dispersed therein. The man skilled in the art will know the polymerization conditions to be used when selecting the monomers. The step of exposing the reaction mixture to polymerization conditions may also include activation of a polymerization initiator or catalyst.

In a preferred embodiment, said carbon conductive loads are carbon black particles, graphene, carbon nanofibers or carbon nanotubes or mixture thereof. The amount of carbon conductive loads is preferably comprised between 0.5 and 5.0 wt.% to directly form an electromagnetic interference shielding material. EMI shielding material precursors, on the other hand, preferably an amount of carbon conductive load less than 50 wt.%, preferably between 5.0 and 15 wt.%, so that an EMI shielding material can be produced very easily with a tailored carbon load content comprised between 0.5 and 5.0 wt.% by mixing the easy to handle precursor with an unloaded, or low carbon content polymer.

Preferably, said carbon conductive loads are carbon nanotubes (CNTs). The CNTs may be single-wall CNTs, double-wall CNTs, multi-wall CNTs or combinations thereof. In a particularly preferred embodiment, the CNTs are multi-wall CNTs. In a preferred embodiment, CNTs are not functionalized. By using non-functionalized carbon nanotubes, the efficiency of surface-grafting of said carbon nanotubes by parts of the polymer chains made during the polymerization process is enhanced.

At the end of the reaction substantially all the carbon conductive loads are dispersed in the first polymer matrix. The remaining solution is clear confirming that carbon conductive loads are dispersed in the polymer matrix of the electromagnetic interference shielding material. The remaining solution can be recycled.

In a preferred embodiment, the process may further comprise the step of ultrasonication of the reaction mixture in step (a) of the process.

In a preferred embodiment, the process may further comprise the step of filtering and washing the electromagnetic interference shielding material thus obtained. As discussed supra, the solvent and monomers still dissolved therein thus recovered may be recycled into the process.

In a preferred embodiment, the process may further comprise the step of foaming the electromagnetic interference shielding material. Foaming may be performed by the use of a physical or a chemical foaming agent. Physical foaming agents such as e.g. molecular nitrogen and carbon dioxide (CO₂) are gaseous agents. These gases are soluble in particular molten state polymers under high pressure. By depressurising the system in which foaming is performed, a combination of nucleation and bubble growth generates a cellular structure in the composite material. The use of e.g. CO₂ in a supercritical state (scCO₂), i.e. a fluid having an intermediate behaviour between gas and liquid state, presents many advantages, in particular non-toxicity compared with chemical foaming agents (see further) since no solid residues or toxic gases are produced in the foamed structure. Moreover, the inert nature of gases allows foaming at very low temperatures under safe conditions. The dissolution of scCO₂ in the polymer matrix (before its expansion) also gives rise to a drop of the transition temperature or melting temperature of the polymer (Tg or Tm). In this way, the process with scCO₂ can be implemented at temperatures lower than the initial Tg or Tm, hereby making foaming of thermosensitive matrixes also possible. Examples of chemical foaming agents may be porogene agents such as e.g. azodicarbonamide, which are generally used in the form of powders which decompose at relatively high temperatures, e.g. typically 170°C for azodicarbonamide, in the presence of a decomposition accelerating agent or decomposition catalyst such as e.g. zinc oxide and/or zinc stearate. The amount of foaming agent, expressed in weight percent compared to polymer, may be between 5% and 20%, for example between 10% and 15%. The amount of decomposition catalyst, expressed in weight percent compared to polymer, may preferably be between 1 % and 10%, for example between 3% and 5%. In making some foams such as, for example, polyurethane foams, an amount of a surfactant may be added to stabilize the foaming reaction mixture until it cures. All surfactants used for stabilizing polyurethane foams known by a person skilled in the art can be used with the present invention.

The overall amount of carbon conductive loads in the electromagnetic interference shielding material may be controlled. The present process may comprise the step of mixing the material precursor obtained in step (c) with a second polymer matrix. Said second polymer matrix must have a lower carbon content than the material precursor, and is actually preferably free of carbon conductive loads. Hence, it is possible to produce directly an EMI shielding material by introducing initially in step (a) of the process a small amount of carbon conductive loads, for example less than 5wt% of carbon conductive loads or, alternatively, to produce an EMI shiedling material precursor introducing initially higher amounts of carbon conductive loads and then mix the resulting precursor material with a second polymer matrix to yield an EMI shielding material with a desired amount of carbon conductive loads. The overall amount of carbon conductive loads in the electromagnetic interference shielding material is preferably comprised between 0.5 and 5.0 wt.%, whilst the carbon content in a precursor may be less than 50wt%, preferably less than 20wt%, more preferably less than 10wt%. It should of course be superior to 0.5 wt.% and it most preferably ranges from 0.5 wt% to 10 wt%.

Said second polymer matrix may be a polymer selected from the group consisting of polylactic acid, polyglycolic acid, polyhydroxyalkanoate, polyacrylates, polymethacrylates, polystyrene, polyurethanes, polycarbonates, polyamides, polyetheretherketones, polyvinylalcohols, polyesteramines, polyesteramides, polysulfones, polyimides, polyethyleneglycol, fluorinated polymers, polyvinyl chloride, polychloroprene, polyacrylonitrile, polyacrylamides, poly(α-olefins), poly(1,4-dienes), styrene/acrylonitrile copolymers (SAN) or mixtures thereof.

In a preferred embodiment, the polymerizable medium comprises a polymerization initiator, such as a radical initiator, and thus the reaction mixture is exposed in step (b) to radical polymerization conditions. A radical initiator would be suitable for the polymerization of one or more monomers independently selected from the group consisting of C₃₋₁₀ cycloalkene or an alkene of general formula R¹R²C=CR³R⁴ wherein R¹, R², R³, R⁴ are substituent independently selected from the group consisting of hydrogen, -OR, -CN, -COOR, -NR₂, -SO₃R, -P(O)(OR)₂, and unsubstituted or substituted C₁₋₁₀ alkyl, C₃₋₁₀ cycloalkylene, C₃₋₁₀ cycloalkyl or C₆₋₁₀ aryl groups.

In another preferred embodiment, less than 5wt% of the polymer chains are grafted on part of the surface of the carbon conductive loads, preferably less than 3wt%. This ensures, on the one hand, an optimized dispersion of the carbon load within the polymer matrix and, on the other hand, the prevention of the isolation from one another of each individual carbon load particle by a substantial polymeric coating.

In a second aspect, the present invention provides an electromagnetic interference shielding material or a precursor thereof comprising a first polymer matrix and carbon conductive loads dispersed therein prepared by the process according to the present invention. Said electromagnetic interference shielding material may further comprise a second polymer matrix.

Said first and second polymer matrix may be a polymer independently selected from the group consisting of polylactic acid, polyglycolic acid, polyhydroxyalkanoate, polyacrylates, polymethacrylates, polystyrene, polyurethanes, polycarbonates, polyamides, polyetheretherketones, polyvinylalcohols, polyesteramines, polyesteramides, polysulfones, polyimides, polyethyleneglycol, fluorinated polymers, polyvinyl chloride, polychloroprene, polyacrylonitrile, polyacrylamides, poly(α-olefins), poly(1,4-dienes), styrene/acrylonitrile copolymers (SAN) or mixtures thereof.

Preferably, said carbon conductive loads are carbon black particles, graphene, carbon nanofibers or carbon nanotubes or mixture thereof. Preferably, said carbon conductive loads are carbon nanotubes (CNTs). The CNTs may be single-wall CNTs, double-wall CNTs, multi-wall CNTs or combinations thereof. In a particularly preferred embodiment, the CNTs are multi-wall CNTs. In yet a preferred embodiment, CNTs are not functionalized. In another preferred embodiment, the overall amount of carbon conductive loads in said electromagnetic interference shielding material precursor may be less than 50wt%, preferably less than 20wt%, more preferably less than 10wt% and the carbon amount in the EMI shielding material preferably ranges from 0.5 wt% to 5.0 wt%.

According to the present invention, the surface of said carbon conductive loads dispersed in the polymer matrix is partly grafted by a fraction of the polymer chains formed during the polymerization step (b) of the present process. Hence, the surface of the carbon conductive loads may be partly grafted by polymer chains selected from the group listed above.

In a preferred embodiment, said electromagnetic interference shielding material has a reflectivity less than -2 dB, preferably ranging from - 5 dB to -20 dB at a frequency greater than 1 GHz. In another preferred embodiment, said electromagnetic interference shielding material has a shielding effectiveness of less than -5 dB, preferably less than -10 dB, more preferably ranging from -5 dB to -90 dB at a frequency higher than 1 GHz. The electrical conductivity of said electromagnetic interference shielding material may range at least 1 S/m at frequency of at least 1 GHz.

### Examples

### Materials

Methyl methacrylate (>99%, Aldrich), alpha,alpha'-azoisobutyronitrile (AIBN) (Fluka), methanol (Aldrich) and dimethylformamide were used as received. Multi-Walled Carbon Nanotubes (CNTs) produced by Chemical Vapor Deposition (CVD) were provided and purified by FutureCarbon. Polymethylmetacrylate (PMMA) (Diakon®) was provided by ICI.

### Example 1: Preparation of the electromagnetic interference shielding material by the process of the invention

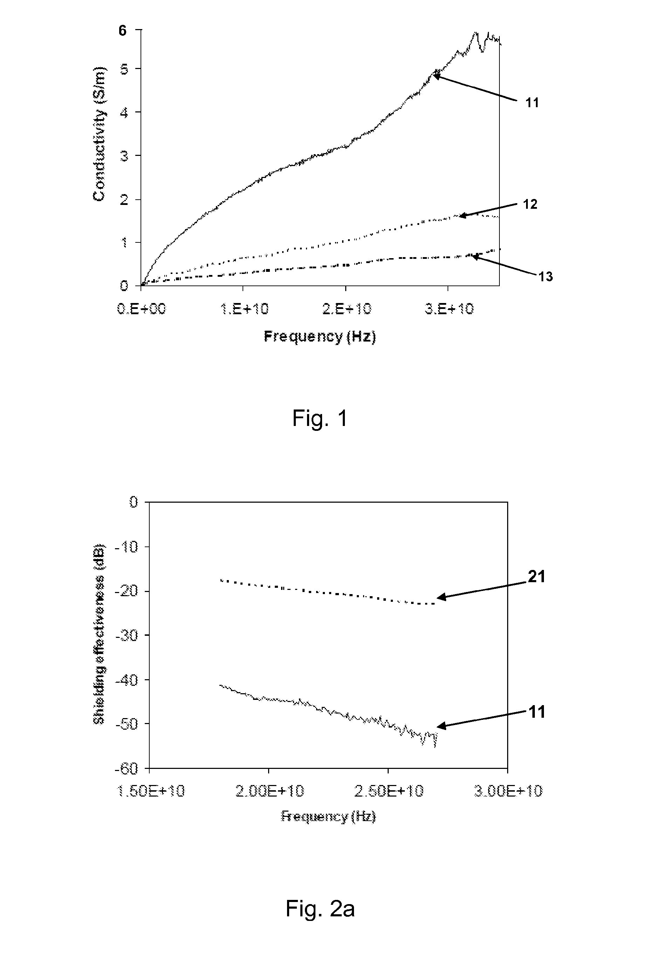

The electromagnetic interference shielding material was prepared by the process of the present invention. In a typical experiment, CNT (150 mg) have been dispersed in 100 ml of methanol and placed in an ultrasonic bath (35kHz, 320W, Sonorex RK 255H) for 30 min. 0.1 g of AIBN and 15g of MMA are then added and the solution is degassed by nitrogen. The solution is placed again in an ultrasonic bath for 10 min at room temperature. Then, the mixture is heated at 60°C while stirring with a magnetic stirrer. During its formation, the polymer poly(methyl methacrylate) (PMMA) precipitates entrapping most of CNTs. When the monomer conversion reached 50%, the reaction is stopped and the solid sample is removed from the solution with a pincer and washed with methanol. The PMMA was loaded with 2 wt.% CNT. This material is referred in Figures 1 to 3 with the numeral 11.

### Comparative example 2: Preparation of the material by melt-mixing

The electromagnetic interference shielding material was prepared by melt-mixing technique. The melt-mixing the PMMA with the required amount of CNTs (2 wt.%) has been performed at 210°C in a 5 cm3 DSM micro-extruder under nitrogen at 200 rpm for 10 min. This material is referred in Figure 1 with the numeral 13.

### Comparative example 3: Preparation of the material by co-precipitation

The electromagnetic interference shielding material was prepared by co-precipitation technique. 10 g of PMMA are dissolved in 400 ml of DMF and the required amount of CNTs (2wt%) was added to the solution. After 30 min of an ultrasonic treatment, the solution was precipitated in 4L of a non-solvent of PMMA, i.e., methanol. The sample was then collected by filtration and washing with methanol. This material is referred in Figure 1 with the numeral 12.

### Foaming of the material

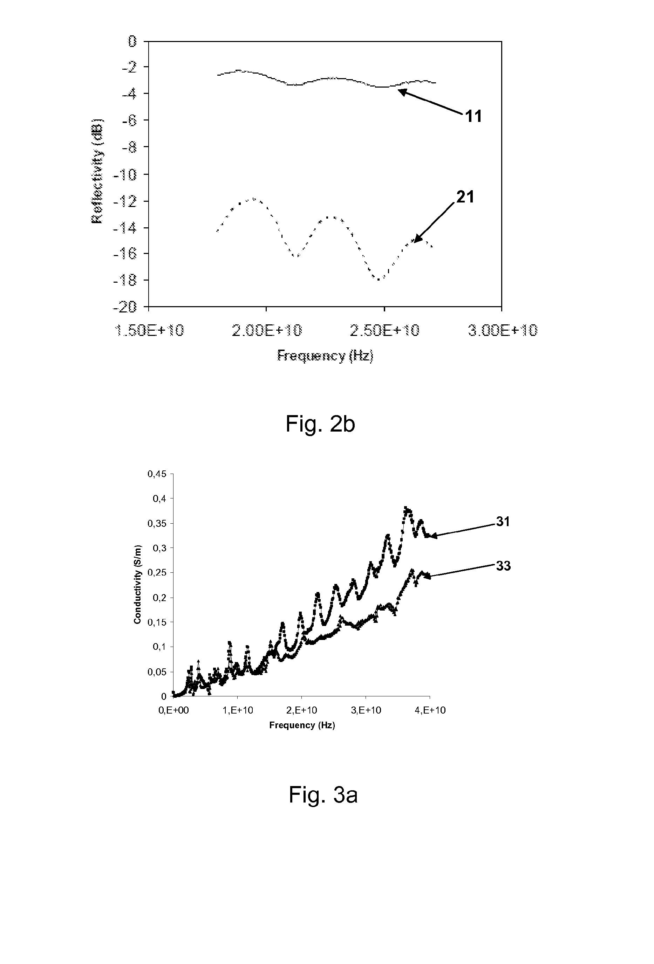

21x7x3 mm samples of the PMMA/CNTs material according to the present invention as described in example 1 have been prepared by compression moulding (200°C, 80 bars, 2 min.) and foamed using supercritical CO₂ in a two steps process. The samples are placed in a 316 stainless steel high pressure cell (100 ml) from Parr Instruments pressurized with CO₂ at 45 bar with an ISCO 260D high pressure syringe pump. The cell was then heated to 40 °C, and compressed CO₂ was finally added to a final pressure of 280 bar. This saturation pressure was maintained for 16h before being released within a few seconds. At this temperature (well below the glass transition of PMMA), no foaming occurs. The samples are then placed in a hot press at 120°C for 5 min to induce the expansion of the polymer. The volume of the mould used (30x11.75x5mm) is 4 times the volume of the non-foamed samples to have the same volume expansion in all cases. This material is referred to in Figures 2a and 2b with the numeral 21.

### Physical properties

The 2 wt.% carbon nanotube composites prepared as described above were observed with a transmission electron microscope PHILIPS M100 at an accelerating voltage of 100 kV. Thin sections (90 nm) were prepared by ultramicrotomy (ULTRACUT E from REICHERT-JUNG) at -130°C. Micrographs were analyzed by using the megaview GII (Olympus) software. The foam structures were observed by scanning electron microscopy (SEM; JEOL JSM 840-A) after metallization with Pt (30 nm). Electrical measurements were performed with a Vector Network Analyser Model Wiltron 360B operating over the frequency range 40MHz-40GHz. Each nanocomposite sample to be characterized consists of a thin plate of same thickness (1 mm) and surface (4x4 mm2) prepared by compression moulding (200°C, 80 bars, 2 min.), and is used as a microwave substrate on which a ground plane and a microstrip line are deposited (Saib et al. IEEE Trans. Microwave Theory Tech., 2006, 54, 2745-2754). This ensures broadband guided propagation of the signal inside the nanocomposite substrate. A standard calibration of the VNA is performed before measuring the microstrip configuration, in order to remove any influence of the connecting cables and of their transitions to the sample. Measurements provide the so-called vector S-parameters S₁₁ and S₂₁. Parameter S₁₁, measured when short-circuit reflective termination is placed at the output of the sample, corresponds to the reflectivity, R = 20 log10 |S₁₁|, i.e. the reflected power measured at input interface of the substrate, normalized to input power. Parameter S₂₁ corresponds to normalized transmission through nanocomposite. Hence the shielding effectiveness SE is simply equal to - 20 log₁₀ |S2|. From those Sij measurements the conductivity of each nanocomposite is also extracted.

Fig.1 represents the electrical conductivity as a function of frequency of an electromagnetic interference shielding material comprising poly(methyl methacrylate) as polymer matrix and 2 wt.% carbon nanotubes prepared by three different processes (Example 1 to 3). All samples tested were in non-foamed state. Curve 11 represents the conductivity of the electromagnetic interference shielding material prepared by the process of the invention as described in example 1. Curve 12 represents the conductivity of the electromagnetic interference shielding material of example 3. Curve 13 represents the conductivity of the electromagnetic interference shielding material of example 2. The conductivity of the electromagnetic interference shielding material prepared by the process of the invention achieved more than 4 S/m at about 25 GHz (curve 11), when the conductivity of electromagnetic interference shielding material prepared by the two other methods was below 2 S/m (curve 12 and 13 Fig 1). The process of the invention allows to prepare an electromagnetic interference shielding material with an excellent conductive network. The process of the present invention was more favourable for scaling-up since it is less solvent consuming compared with the co-precipitation technique. Compared with the melt-mixing method, the process of the present invention is more favourable since the CNTs are neither broken nor crushed during the process.

Fig. 2a represents the shielding effectiveness (SE) as a function of frequency of an electromagnetic interference shielding material comprising a polymer matrix made of poly(methyl methacrylate) and 2wt% of carbon nanotubes. The electromagnetic interference shielding material was prepared by a process of the invention as described in example 1. Curve 11 corresponds to SE of the material in non-foamed state, and curve 21 corresponds to SE of the material in foamed state as described in Example 4. The shielding effectiveness was lower than -40 dB in non-foamed state (curve 11) and lower than -15 dB in foamed state (curve 21). Therefore, excellent results of conductivity and shielding effectiveness were obtained for electromagnetic interference shielding material prepared by the process of the invention.

Fig. 2b represents the reflectivity (R) as a function of frequency of an electromagnetic interference shielding material comprising a polymer matrix made of poly(methyl methacrylate) and 2 wt% of carbon nanotubes and prepared by the process of the invention. Curve 11 corresponds to the reflectivity of the material in non-foamed state. The reflectivity was superior to -3dB which means that more than the half of the incident signal power is reflected. Curve 21 corresponds to the reflectivity of the material in foamed state as described in Example 4. The material exhibited a reflectivity lower than -15dB. Electromagnetic interference shielding materials of the present invention exhibit a surprising absorption/reflectivity ratio since from the incident radiation power, only 1% was transmitted (SE < -20dB) and only 3% was reflected (R < -15dB).

### Example 4: Preparation of a material precursor made of poly(methyl metha crylate) and carbon nanotubes in poly(styrene-co-acrylonitrile) (SAN) by the process of the present invention

In a typical experiment, 1.5 g CNT have been dispersed in 400 ml of methanol and placed in an ultrasonic bath (35kHz, 320W, Sonorex RK 255H) for 30 min. 0.1 g of AIBN and 15 g of MMA are then added and the solution is degassed by nitrogen. The solution is placed again in an ultrasonic bath for 10 min at room temperature. Then, the mixture was heated at 60°C while stirring with a magnetic stirrer. After 48h, the reaction is stopped and the solid sample is collected by filtration and dried under vacuum for 24h at 50°C to form an EMI shielding material precursor having 10wt% of CNT dispersed in PMMA polymer matrix. SAN were added at 180°C in a 5 cm³ DSM micro-extruder under nitrogen at 200 rpm for 10 min with the required amount of the resulting PMMA/CNT material to obtain an electromagnetic interference shielding material having an overall CNTs concentration of 2wt%. This material is referred n Figure 3a with the numeral 31.

### Comparative example 5: Preparation of a material made of poly(methyl metha crylate and carbon nanotubes in poly(styrene-co-acrylonitrile) (SAN) by melt-mixing

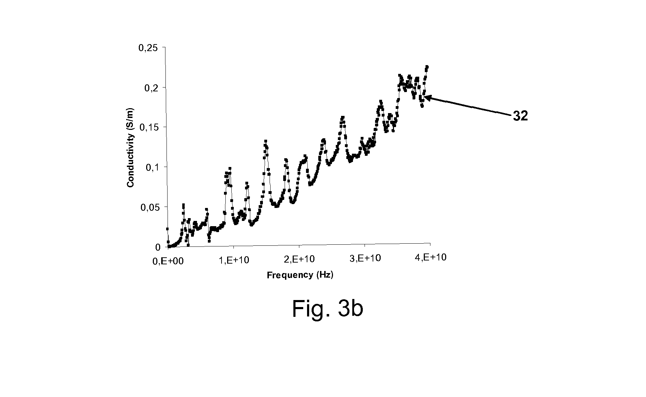

The melt-mixing of PMMA with the required amount of CNTs (10wt%) has been performed at 210°C in a 5 cm3 DSM micro-extruder under nitrogen at 200 rpm for 10 min. SAN were added at 180°C in a 5 cm³ DSM micro-extruder under nitrogen at 200 rpm for 10 min with the required amount of PMMA/CNT materials to obtain an overall CNTs concentration of 2wt%. This material is referred to in Figure 3b with the numeral 32.

Figure 3a and 3b show that EMI shielding material made of PMMA/CNT in poly(styrene-co-acrylonitrile) prepared according to the process of the present invention (example 4 - curve 31) has enhanced conductivity compared with the same material prepared by melt-mixing (comparative example 5 - curve 32) and compared to an EMI shielding material prepared by directly melt-mixing SAN with 2wt% CNTs at 180°C (curve 33).

The terms and descriptions used herein are set forth by way of illustration only and are not meant as limitations. Those skilled in the art will recognize that many variations are possible within the spirit and scope of the invention as defined in the following claims, and their equivalents, in which all terms are to be understood in their broadest possible sense unless otherwise indicated. As a consequence, all modifications and alterations will occur to others upon reading and understanding the previous description of the invention. In particular, dimensions, materials, and other parameters, given in the above description may vary depending on the needs of the application.

## Claims

1. Process for preparing an electromagnetic interference shielding material, or a precursor thereof, comprising a first polymer matrix and carbon conductive loads, said process comprises the steps of:
(a) Forming a reaction mixture comprising carbon conductive loads and a polymerizable medium said polymerizable medium comprising one or more monomers dissolved in a solvent,
(b) Exposing the reaction mixture to polymerization conditions to polymerize said polymerizable medium and thus form a polymer, and
(c) Forming a precipitate or an agglomerate of an electromagnetic interference shielding material made of less than 50 wt.% carbon conductive loads dispersed in the first polymer matrix formed in step (b),
**characterized in that**, said polymer is insoluble in said solvent and **in that** a fraction of the polymer chains thus formed are grafted on part of the surface of the carbon conductive loads.

2. Process according to claim 1 **characterized in that** said carbon conductive loads are carbon black particles, graphene, carbon nanofibers or carbon nanotubes, or mixture thereof.

3. Process according to claim 1 or 2 **characterized in that** said one or more monomers are selected from the group consisting of:
(i) C₃₋₁₀ cycloalkene or an alkene of general formula R¹R²C=CR³R⁴ wherein R¹, R², R³, R⁴ are substituent independently selected from the group consisting of hydrogen, -OR, -CN, -COOR, -NR₂, -SO₃R, -P(O)(OR)₂, and unsubstituted or substituted C₁₋₁₀ alkyl, C₃₋₁₀ cycloalkylene, C₃₋₁₀ cycloalkyl or C₆₋₁₀ aryl groups;
(ii) hydroxyalkanoate of general formula HO-(CR⁵R⁶)ₙ-CO₂H wherein n is an integer from 1 to 10, R⁵ and R⁶ are independently selected in each n units from the group consisting of hydrogen, and unsubstituted or substituted C₁₋₁₀ alkyl, C₃₋₁₀ cycloalkylene, C₃₋₁₀ cycloalkyl or C₆₋₁₀ aryl groups,
(iii) a mixture of diol or polyols and diisocyanates or polyisocyanates having from 2 to 20 aliphatics, araliphatics or cycloaliphatics carbons, the prefix "poly" as used herein refers to compounds bearing more than two hydroxyl or isocyanate functional groups,
(iv) compound of general formula X¹-R⁶-X² wherein X¹ and X² are functional groups selected from the group consisting of CO₂H, NH₂, OH, halogen, -S(O)₂-R⁷ and salts thereof; R⁶ and R⁷ are independently selected from the group consisting of unsubstituted or substituted C₁₋₁₀ alkyl, C₃₋₁₀ cycloalkylene, C₃₋₁₀ cycloalkyl or C₆₋₁₀ aryl groups,
(v) a mixture comprising a ketone of general formula X³-R⁸-CO-R⁹-X⁴ and an dialkoxide HO-R¹⁰-OH or salts thereof, wherein R⁸, R⁹, R¹⁰ are independently selected from the group consisting of and unsubstituted or substituted C₁₋₁₀ alkyl, C₃₋₁₀ cycloalkylene, C₃₋₁₀ cycloalkyl or C₆₋₁₀ aryl groups; X³ and X⁴ are independently selected from the group consisting of F, Br, Cl and I, and
(vi) a mixture comprising a dianhydride and a compound of general formula X⁵-R¹¹-X⁶ and wherein X⁵ and X⁶ are functional groups selected from the group consisting of NH₂ and N=C=O, and R¹¹ is unsubstituted or substituted C₁₋₁₀ alkyl, C₃₋₁₀ cycloalkylene, C₃₋₁₀ cycloalkyl or C₆₋₁₀ aryl groups; or ether of general formula R¹²-O-R¹³ wherein R¹² and R¹³ are independently selected from the group consisting of unsubstituted or substituted C₁₋₁₀ alkyl, C₃₋₁₀ cycloalkylene, C₃₋₁₀ cycloalkyl and C₆₋₁₀ aryl groups,
said one or more monomers being preferably as defined in (i) supra.

4. Process according to any of the previous claims **characterized in that** said solvent is selected from the group consisting of supercritical carbon dioxide, C₅₋₁₅ alkane, C₁₋₁₀ alcohol, hydrocarbon bearing a functional group selected from the group consisting of ether, ester, ketone, aldehyde, sulfoxide, nitrile, and amide; water and unsubstituted or substituted C₆₋₁₀ aryl groups.

5. Process according to any of the previous claim **characterized in that** said process further comprises the step of ultrasonication of the reaction mixture in step (a) of the process.

6. Process according to any of the previous claims **characterized in that** said process further comprises the step of filtering and washing the electromagnetic interference shielding material formed in step (c).

7. Process according to any of the previous claims **characterized in that** said process further comprises the step of foaming the electromagnetic interference shielding material.

8. Process according to any of the previous claims **characterized in that** it comprises the step of mixing the material obtained in step (c) with a second polymer matrix to control the overall amount of carbon conductive loads in the electromagnetic interference shielding material to an amount comprised between 0.5 and 5.0 wt.%.

9. Process according to any of the previous claims **characterized in that** said polymerization medium further comprises a polymerization initiator and/or a catalyst, and **in that** exposing the reaction mixture to polymerization conditions includes activating said polymerization initiator or catalyst.

10. Process according to the previous claim, wherein the initiator is a radical initiator, and said reaction mixture is exposed in step (b) to radical polymerization conditions.

11. Process according to any of the previous claims **characterized in that** less than 5 wt% of the polymer chains are grafted on the surface of the carbon conductive loads, preferably, less than 3 wt%.

12. An electromagnetic interference shielding material comprising a first polymer matrix and carbon conductive loads dispersed therein formed by a process according to any of the previous claims, the surface of said carbon conductive loads being partly grafted with a fraction of the polymer chains formed during said process.

13. An electromagnetic interference shielding material according to claim 12 **characterized in that** said electromagnetic interference shielding material has a reflectivity less than -2 dB, preferably ranging from -5 dB to -20 dB at a frequency higher than 1 GHz.

14. An electromagnetic interference shielding material according to claim 12 or 13 **characterized in that** said electromagnetic interference shielding material has a shielding effectiveness of less than -5 dB, preferably less than -10 dB, more preferably ranging from -5 dB to -90 dB at a frequency higher than 1 GHz.

15. Method for shielding a surface or a volume from a source of electromagnetic radiations comprising the steps of:
- Preparing an electromagnetic interference shielding material by the process according to any of claims 1 to 11,
- Shaping said electromagnetic interference shielding material to form an electromagnetic interference shield, and
- Interposing said electromagnetic interference shield between said surface or volume and said source of electromagnetic radiation.
